# FASCICULE DE BREVET EUROPEEN

(11) **EP 1 111 508 B1**
(45) Date de publication et mention de la délivrance du brevet: **14.05.2003**
(21) Numéro de dépôt: 99125741.1
(22) Date de dépôt: 23.12.1999
(51) Int. Cl.: G06F 11/00, G01R 31/30

(54) **Circuit intégré pourvu de moyens de calibrage d'un module électronique, et procédé de calibrage d'un module électronique d'un circuit intégré**
Integrierte Schaltung mit Kalibriermitteln zur Kalibrierung eines elektronischen Moduls und Verfahren zum Kalibrieren eines elektronischen Moduls in einer Integrierten Schaltung
Integrated circuit with calibration means for calibrating an electronic module, and method for calibrating an electronic module in an integrated circuit

(43) Date de publication de la demande: 27.06.2001
(73) Titulaire: EM Microelectronic-Marin SA, 2074 Marin (CH); Advanced Technology Materials, Inc., Danbury, CT 06810-4169 (US)
(72) Inventeur: Walter, Fabrice, 2074 Marin (CH); Ratajczak, Christophe, 2034 Peseux (CH)
(74) Mandataire: Laurent, Jean

(56) Documents cités:
- US-A- 5 319 370
- US-A- 5 790 469

## Description

L'invention concerne un circuit intégré pourvu de moyens de calibrage d'au moins un module électronique, un procédé pour calibrer en phase de test au moins un module électronique de tels circuits intégrés, ainsi qu'une plaquette de circuits intégrés pourvu de moyens de calibrage.

Après avoir passé les étapes de fabrication, les circuits intégrés sur des plaquettes ou substrats semi-conducteurs sont testés communément par un appareil de test à cartes à pointes. Plusieurs lots de plaquettes sont mis par exemple en attente dans l'appareil programmé avant que les plaquettes soient saisies et placées chacune sur un support de test afin de recevoir les aiguilles de test sur les plages correspondantes des circuits intégrés à tester. Habituellement, lesdits circuits sur la plaquette ou le substrat sont testés les uns après les autres grâce à une carte à pointes se posant sur les plages de contact d'un des circuits à tester.

La plupart des circuits intégrés, par exemple dans le domaine basse tension, requiert de garantir des tensions de référence, des fréquences de référence et/ou des bases de temps précises pour différent blocs électroniques des circuits. Etant donné que la marge de variation des paramètres électriques due au procédé de fabrication est relativement importante sur chaque plaquette de circuits intégrés, il est parfois nécessaire de calibrer certains paramètres de chaque circuit intégré.

Actuellement, le calibrage est réalisé individuellement pour chaque circuit intégré pour obtenir des valeurs de référence précises en agissant sur des éléments électroniques internes ou externes. Dans ce cas, l'emploi de cartes à pointes multiples pour le test simultané de plusieurs circuits intégrés n'est donc pas possible, ce qui rallonge le temps de test des circuits intégrés et occasionne de surcroît des coûts supplémentaires dans la chaîne de production.

Des facilités pour le test de circuits intégrés d'un substrat semi-conducteur peuvent consister à prévoir des pistes métalliques dans des bandes de sciage du substrat séparant chaque circuit intégré, pour relier des plages d'entrée ou de sortie de signaux de plusieurs circuits. La connexion de plusieurs circuits intégrés grâce à ces pistes métalliques permet d'opérer certains tests des circuits de manière individuelle ou en commun.

Le brevet US 5648661 décrit un tel agencement de pistes métalliques dans les bandes de sciage pour faciliter le test de plusieurs circuits intégrés sur un même substrat ou plaquette sans nécessiter l'emploi de cartes à pointes compliquées, ce qui permet de gagner du temps de test. Les pistes métalliques disparaissent après le sciage de la plaquette pour séparer chaque circuit intégré. Il est à noter qu'aucun moyen de calibrage de modules électroniques des circuits intégrés n'est prévu et que la réalisation desdites pistes métalliques requiert normalement une étape supplémentaire dans la réalisation des circuits intégrés, ce qui est un inconvénient.

D'autres appareils ont été proposés pour pouvoir calibrer certains paramètres électriques de circuits intégrés en phase de test. Pourtant, même si plusieurs circuits intégrés pouvaient être branchés en même temps par une carte à pointes multiple, il serait nécessaire de calibrer chaque circuit intégré de manière individuelle.

Le brevet US 4928278 décrit un système de test d'un circuit intégré afin de pouvoir tester des fonctions variées dudit circuit. Pour cela, le système exécute automatiquement le calibrage d'erreurs de synchronisation de plusieurs unités électroniques fournissant des signaux de test en parallèle au circuit intégré testé. Dans ce document, le calibrage ne concerne pas des modules électroniques du circuit intégré, mais uniquement de l'appareil de test, ce qui complique l'infrastructure de test du circuit.

Le document US-A- 5 790 469 divulgue un dispositif et une méthode de calibration d'un générateur de tension comportant toutes les caractéristiques qui sont définies dans le préambule des revendications indépendantes proposées.

Un but que se propose de résoudre l'objet de l'invention consiste en un circuit intégré pourvu de moyens de calibrage d'au moins un module électronique de référence afin que le signal de sortie dudit module soit calibré précisément pour pallier aux inconvénients décrits ci-devant.

Un autre but que se propose de résoudre l'objet de l'invention consiste en un procédé de calibrage en phase de test d'au moins un module électronique de circuits intégrés afin que le signal de sortie dudit module soit calibré précisément pour pallier aux inconvénients décrits ci-devant.

Ces buts, ainsi que d'autres sont atteints grâce au circuit intégré tel que revendiqué dans la revendication 1.

Ces buts, ainsi que d'autres sont également atteints grâce au procédé de calibrage tel que revendiqué dans la revendication 8.

Ces buts, ainsi que d'autres sont également atteints grâce à une plaquette de circuits intégrés qui se caractérise en ce que lesdits circuits intégrés sont agencés sur la plaquette en fonction de l'emplacement de leurs plages d'entrée et de sortie de signaux afin de permettre aux aiguilles d'une carte à pointes d'une machine de test de pouvoir se poser sur les plages d'un groupe de circuits intégrés pour pouvoir tester et calibrer tous les circuits du groupe en même temps.

Un avantage du circuit intégré est qu'il est capable d'opérer de manière autonome un calibrage d'un signal de référence interne d'un module de référence intégré, tel qu'une tension de référence, une base de temps ou une fréquence de référence, sur la base d'un signal de référence externe imposé et souhaité. Dès que la phase de calibration est terminée, un mot de calibrage spécifique, formant les paramètres finals de calibrage, est enregistré dans une mémoire interne, par exemple une mémoire EEPROM, ainsi que la signature associée.

Cette mémorisation finale de calibrage évite qu'à chaque mise sous tension subséquente du circuit, il soit nécessaire d'entreprendre une nouvelle opération de calibrage et qu'un autre signal de référence externe puisse permettre un autre calibrage non désiré des modules de référence. A cette fin, dès la mise sous tension du circuit intégré, un contrôle est donc opéré pour savoir s'il y a une signature enregistrée dans ladite mémoire. Dans l'affirmative, aucune procédure de calibrage n'est lancée, car le mot de calibrage de la mémoire est appliquée directement au module de référence.

Par sécurité, il peut être envisagé de n'avoir aucune plage d'entrée ou de sortie de signaux sur le circuit reliant directement la sortie du ou des modules électroniques de référence afin d'éviter que quiconque puisse avoir accès facilement à ces parties du circuit. La seule plage d'entrée accessible pour agir sur les modules de référence reste celle utilisée pour le calibrage du module correspondant. Cette plage de calibrage ne permet normalement plus d'agir sur le module de référence après l'opération terminée de calibrage.

Un autre avantage consiste en ce que des groupes de circuits intégrés d'une même plaquette peuvent être calibrés successivement de manière autonome à l'aide d'un signal de référence externe appliqué en même temps à un groupe de circuits en phase de test. Bien entendu, d'autres tests sur les circuits peuvent être entrepris en plus des étapes de calibrage des modules de référence de manière groupée ou de manière individuelle. Pour cela, une carte à pointes se posant sur un groupe de circuits intégrés voisins permet d'alimenter en tension électrique chaque circuit du groupe et amener en une seule opération le signal de référence sur la plage d'entrée correspondante de chaque circuit pour qu'il puisse se calibrer de manière autonome.

Comme plusieurs circuits se calibrent en même temps et non successivement, cela permet de réduire le temps de test et de calibrage des modules électroniques de référence, ainsi que les coûts dans la chaîne de production sans qu'il soit nécessaire de munir les appareils de test d'une infrastructure spécifique et compliquée.

En une seule opération, tous les circuits intégrés branchés à un même signal de référence externe se calibrent rapidement et de manière autonome par itérations en introduisant dans leur mémoire EEPROM le mot de calibrage avec la signature correspondante en fin de calibrage du module de référence. Cette façon de calibrer des modules de référence-intégrés du circuit lors du test peut se répéter facilement sur un autre groupe de circuits intégrés.

Les buts, avantages et caractéristiques du circuit intégré et du procédé de calibrage apparaîtront mieux dans la description suivante de formes d'exécution illustrées par les dessins sur lesquels
la figure 1 représente schématiquement deux circuits intégrés où une tension de référence est appliquée en même temps aux deux circuits pour calibrer automatiquement leur module de tension de référence,
la figure 2 représente schématiquement deux circuits intégrés où une fréquence de référence est appliquée en même temps aux deux circuits pour calibrer automatiquement leur module oscillateur de référence,
la figure 3 montre une partie des circuits intégrés sur un même substrat tournés chacun de 90° par rapport à son voisin immédiat pour qu'une carte à pointes puisse se poser sur les plages de contact de quatre circuits afin qu'ils soient testés et calibrés en même temps,
la figure 4 montre une partie des circuits intégrés sur un même substrat, à tester et à calibrer en même temps avec une carte se posant sur les plages de contact de quatre circuits disposés en ligne, et
la figure 5 représente un schéma bloc de la procédure des opérations de contrôle et de calibrage à la mise sous tension du circuit intégré.

La description suivante ne décrira pas tous les composants ou blocs électroniques que comportent les circuits intégrés, hormis ceux permettant un calibrage de manière autonome des modules électroniques de référence. Il est bien clair que les moyens de calibrage sont une partie supplémentaire du circuit, ce qui a pour conséquence une perte de place, mais qui est largement compensée par l'avantage ou la facilité de calibrer de manière autonome les modules de référence intégrés.

Lesdits modules de référence sont par exemple un module de tension de référence pour alimenter la plupart des composants électroniques d'une partie analogique et/ou digitale dudit circuit à une certaine tension qui peut être de l'ordre de 2V par exemple, un module oscillateur servant à fournir une fréquence de référence ou également une base de temps pour la synchronisation de différents blocs électroniques dudit circuit. Comme lesdits circuits intégrés peuvent aussi bien comporter des modules de référence fournissant une tension de référence ou un signal à fréquence de référence, les moyens de calibrage du circuit sont agencés pour calibrer automatiquement l'un ou l'autre module de référence. Ce calibrage s'opère normalement de manière successive, mais il pourrait également se faire en parallèle.

Les circuits intégrés sont réalisés habituellement sur des plaquettes de silicium. Après les étapes de fabrication desdits circuits intégrés, il est nécessaire de leur faire subir un test de fonctionnalité des connexions électriques internes, de ses composants ou blocs électroniques. Pour cela, les plaquettes sont amenées en lots dans un appareil de test afin que chaque plaquette puisse être automatiquement saisie et placée sur un support de test. Les aiguilles d'une carte à pointes viennent se poser sur les plages métalliques d'entrée et de sortie de signaux de chaque circuit intégré afin de les tester.

Pendant cette phase de test, l'invention propose de pratiquer un calibrage de certains modules de référence que comporte chaque circuit intégré. Ce calibrage se réalisera de manière autonome par le ou les circuits intégrés alimentés en tension électrique en leur fournissant en même temps un signal de référence externe.

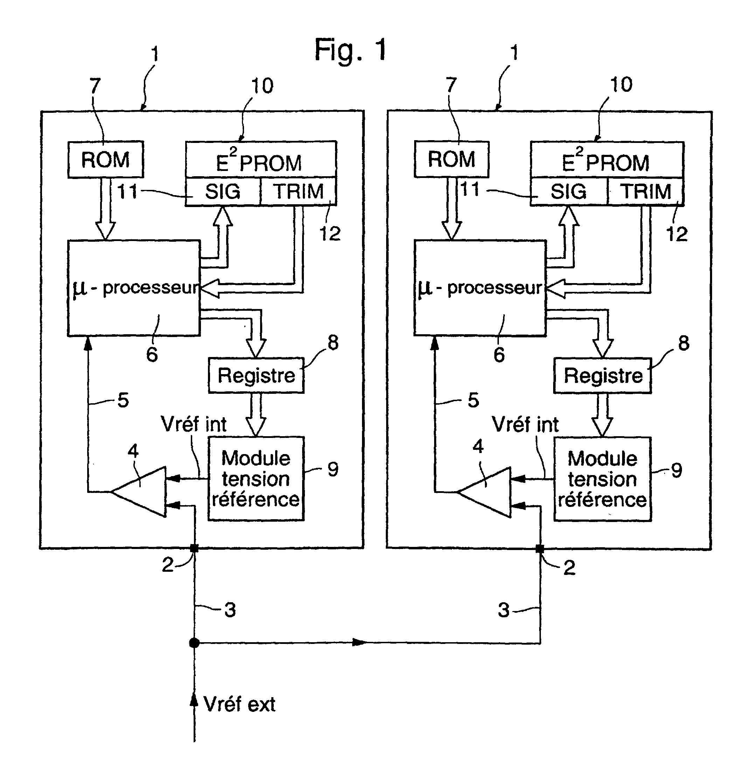

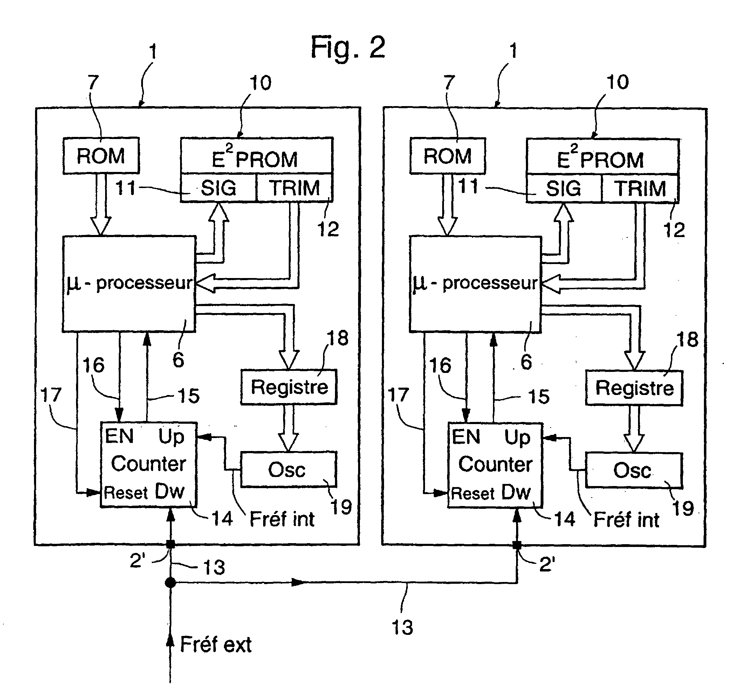

Même si deux circuits intégrés 1 recevant en même temps chacun un signal de référence externe sur une plage d'entrée 2 ou 2' sont représentés de manière schématique aux figures 1 et 2 par simplification, la conception des circuits intégrés est telle qu'elle permet de brancher plusieurs circuits intégrés en même temps pour qu'ils se calibrent de manière autonome.

Le branchement de plusieurs circuits sur un substrat commun est réalisé par exemple à l'aide d'une carte à pointes multiple lors de la phase de test. Dans ces conditions, lors de la fabrication desdits circuits, l'emplacement des plages d'entrée et de sortie de signaux est primordiale pour pourvoir permettre aux aiguilles d'une telle carte à pointes de se poser sur des plages de plusieurs circuits. Le calibrage des circuits intégrés se fait donc pendant le test des circuits, car cela facilite l'ensemble des opérations de test et de calibrage desdites plaquettes.

En figure 1, le signal de référence 3, dans cette première forme d'exécution, est une tension de référence Vréf ext, mais bien entendu, il pourrait s'agir d'un signal de base de temps ou d'un signal à fréquence de référence qui sera expliqué en référence à la figure 2. Cette tension de référence externe 3 est connectée aux deux plages d'entrée de signaux 2 de chaque circuit 1.

Les circuits intégrés 1 de cette première forme d'exécution comprennent des moyens de calibrage d'au moins un module de référence intégré, c'est-à-dire du module de tension de référence 9. Les moyens de calibrage sont constitués par un microcontrôleur bien connu de l'homme du métier. Ce module de tension de référence 9 permet d'alimenter par exemple à une tension régulée de faible valeur une majeure partie des composants électroniques dudit circuit qui n'ont pas été illustrés par simplification.

A la sortie du procédé de fabrication, les paramètres électriques de chaque partie des circuits intégrés sont dans une marge de variation due au procédé et ne sont donc pas définis précisément. Les moyens de calibrage permettent de s'affranchir de cette variation des paramètres électriques en calibrant chaque module de référence grâce à un signal de référence externe.

Les moyens de calibrage des circuits intégrés 1, c'est-à-dire le microcontrôleur, comprennent des moyens de comparaison, tel qu'un comparateur 4 dans cette forme d'exécution recevant à ses entrées la tension de référence externe Vréf ext amenée sur la plage d'entrée 2 et la tension de référence Vréf int fournie par le module de tension de référence 9, la sortie 5 du comparateur 4 fournissant un signal de commande à un microprocesseur 6 qui gère toute la procédure de calibrage du module de tension de référence 9, une mémoire ROM 7 contenant un algorithme connu de calcul de paramètres de calibrage et étant liée au microprocesseur 6 pour lui permettre de calculer des paramètres de calibrage à imposer au module de tension de référence 9 en fonction du résultat de la comparaison du comparateur 4, une mémoire EEPROM 10 reliée au microprocesseur 6 et destinée à enregistrer les paramètres finals de calibrage 12 avec une signature 11 associée. Les paramètres de calibrage calculés par le microprocesseur 6 à l'aide de l'algorithme adéquat enregistré dans la mémoire ROM 7 sont transmis dans un registre de calibrage 8 disposé en tant qu'interface devant le module de tension de référence 9. Les paramètres de calibrage ou le mot de calibrage sont adressés en parallèle dans le registre.

L'opération de calibrage est entreprise par itération jusqu'à ce que le module de tension de référence 9 fournisse en sortie une tension de référence Vréf int qui soit égale à la tension de référence externe Vréf ext souhaitée. L'algorithme de calcul qui est connu de l'homme de l'art peut être un algorithme d'approche linéaire ou d'approximation successive, par exemple par dichotomie.

Dès l'instant où la tension de référence interne Vréf int du module de tension de référence 9 est égale à la tension de référence externe Vréf ext, la sortie du comparateur fournit une information au microprocesseur 6 lui indiquant que le calibrage est terminé. Les paramètres finals de calibrage, c'est-à-dire le mot de calibrage, sont introduits par le microprocesseur 6 normalement de manière permanente dans une portion 12 de la mémoire EEPROM 10 avec une signature 11 associée qui spécifie au circuit que l'opération de calibrage du module de référence correspondant a été exécutée. Dans les dessins, TRIM désigne un mot de calibrage ou des paramètres de calibrage d'un module de référence, et SIG désigne la signature associée auxdits paramètres de calibrage dudit module.

Le calibrage du module de tension de référence 9 peut être réalisé par exemple en modifiant des valeurs de résistances d'un réseau de résistances placées en série ou en parallèle agissant sur la valeur de la tension de référence en sortie dudit module. Une autre façon de calibrer cette tension de référence consiste à adresser un mot binaire à une série d'interrupteurs dont l'ouverture ou la fermeture de chaque interrupteur est commandée par un bit du mot binaire, chaque interrupteur reliant une résistance à une source de courant spécifique. Cette opération de calibrage, dénommée également par le terme anglais trimming, ne sera pas plus amplement décrite, car elle fait partie de la connaissance de l'homme du métier dans ce domaine de l'électronique.

Une fois que le test de tous les circuits intégrés sur plaquette, ainsi que le calibrage de tous leurs modules de référence sont terminés, les circuits intégrés sont séparés l'un de l'autre par une opération de sciage des plaquettes. Lesdits circuits, par la suite, sont montés sur des montages hybrides ou sont encapsulés.

Etant donné que la mémoire EEPROM 10 a mémorisé de manière permanente les paramètres finals de calibrage avec la signature associée, toute mise sous tension subséquente du circuit intégré n'entraîne plus de calibrage des modules de référence par contrôle de la signature enregistrée dans ladite mémoire 10. A chaque fois que le circuit est mis sous tension, la mémoire EEPROM 10 fournit les paramètres finals de calibrage par l'intermédiaire du microprocesseur 6 au registre 8 afin que le module de tension de référence 9 produise une tension de référence calibrée.

La figure 2 représente une deuxième forme d'exécution pour le calibrage de deux circuits intégrés 1 alimentés en parallèle par une source de tension électrique et un même signal de référence 13 appliqué aux plages d'entrée 2' de chaque circuit. Le microprocesseur 6, la mémoire ROM 7 et la mémoire EEPROM 10 sont équivalents au premier mode de réalisation et ne seront plus décrits de manière aussi détaillée. Comme pour la première forme d'exécution en référence à la figure 1, uniquement deux circuits intégrés 1 sont montrés, mais il est bien clair que plusieurs circuits pourraient être branchés en parallèle avec un même signal de référence 13 appliqué à leur plage d'entrée 2' pour qu'ils se calibrent de manière autonome.

Dans cette deuxième forme d'exécution, le module de référence à calibrer est un oscillateur 19 qui fournit en sortie un signal à fréquence de référence Fréf int utilisé notamment pour la synchronisation de différents composants électroniques ou blocs logiques dudit circuit. Ce signal à fréquence de référence Fréf int peut être introduit dans des diviseurs pour définir des bases de temps, notamment pour le cas où le circuit intégré est utilisé dans le domaine horloger.

Le signal à fréquence de référence externe Fréf ext reçu sur les plages d'entrée 2' est amené sur une des entrées d'un compteur 14 dont l'autre entrée reçoit le signal à fréquence interne Fréf int du module oscillateur 19. Le compteur 14 est initialement remis à zéro par un signal d'effacement 17 fourni par le microprocesseur 6. Une fenêtre de lecture des deux signaux à fréquence de référence est imposée par le microprocesseur qui fournit un signal de lecture 16 au compteur 14. Le résultat du compteur de la différence entre les deux fréquences est un signal d'information 15 pour le microprocesseur afin qu'il puisse calculer des paramètres de calibrage grâce à l'algorithme de la mémoire 7. Les paramètres de calibrage, qui sont des mots binaires par exemple, sont transmis dans un registre 18 placé à l'entrée de l'oscillateur 19.

Cette opération de calibrage se poursuit par itération jusqu'à ce que les deux fréquences de référence soient égales. Dès ce moment, les paramètres finals de calibrage de l'oscillateur sont introduits par le microprocesseur 6 normalement de manière permanente dans une portion 12 de la mémoire EEPROM 10 avec une signature 11 associée qui spécifie au circuit que l'opération de calibrage a été exécutée.

Dans le cas où les circuits intégrés comprennent aussi bien un module de tension de référence et un module oscillateur, le calibrage de chacun de ces modules est opéré normalement de manière successive. Les paramètres finals de calibrage de chacun de ces modules de référence avec la signature associée sont placés dans des portions différentes de la mémoire EEPROM.

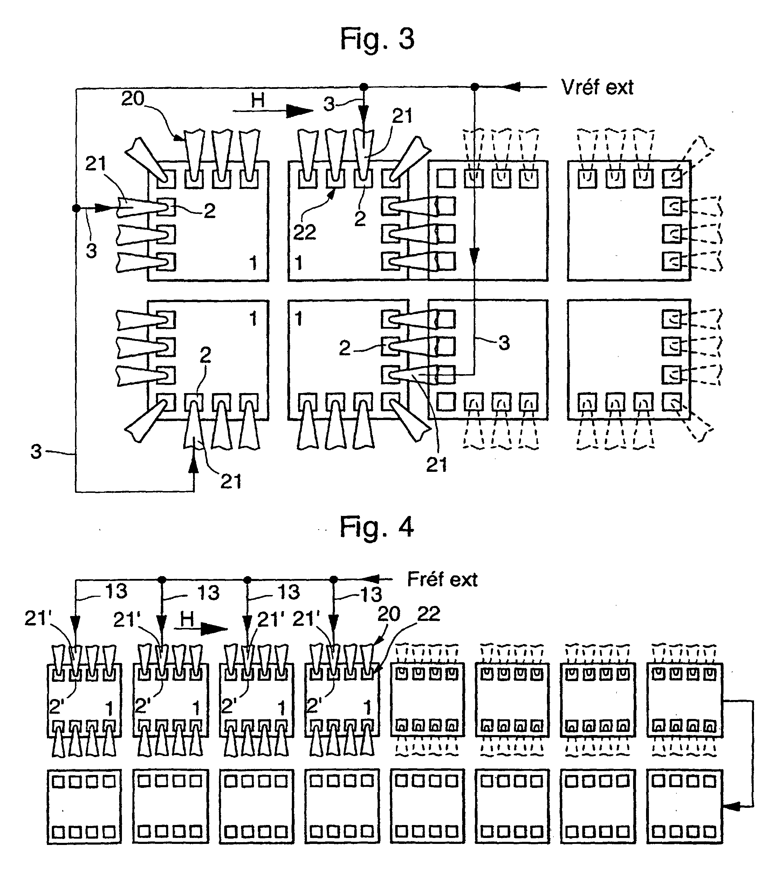

Les figures 3 et 4 sont une représentation de la façon dont sont testés et calibrés plusieurs circuits intégrés 1 en parallèle grâce à une carte à pointes multiples. Les aiguilles 20 de la carte à pointes sont posées sur des plages d'entrée et de sortie de signaux 22 de quatre circuits intégrés 1. Bien entendu, plus de quatre circuits intégrés 1 pourraient être branchés en parallèle selon l'emplacement de leurs plages d'entrée et de sortie de signaux 22. La source de tension électrique pour l'alimentation des circuits intégrés est branchée sur deux desdites plages 22, mais n'est pas illustrée pour ne par surcharger les figures. Ce multiple branchement de circuits intégrés permet aussi bien aux circuits intégrés en parallèle de pratiquer un calibrage de manière autonome de leurs modules de référence, mais également de pouvoir grouper certains tests fonctionnels afin de gagner du temps de test.

A la figure 3, les aiguilles 20 d'une carte à pointes multiple se posent sur les plages 22 de quatre circuits intégrés 1 dont deux circuits sont disposés au-dessus des deux autres circuits. Dans cette configuration, les plages 22 de chaque circuit doivent être agencées de telle façon que les aiguilles 20 de la carte à pointes puissent facilement venir se poser sur lesdites plages 22. Pour cette raison, comme représenté, chaque circuit intégré a des plages 22 tournées de ±90° par rapport à son voisin immédiat. Le circuit intégré disposé en haut à droite a des plages 22 tournées de +90° par rapport au circuit intégré disposé en haut à gauche, tandis que le circuit intégré disposé en bas à gauche a des plages 22 tournées de -90° par rapport au circuit disposé en haut à gauche. Cet ensemble de quatre circuits intégrés a ainsi toutes les plages 22 disposées en périphérie de l'ensemble afin de faciliter la réalisation d'une carte à pointes standard connectant quatre circuits intégrés pour un test et un calibrage multiple. Pour chaque circuit intégré, une aiguille 21 de la carte à pointes se pose notamment sur la plage d'entrée 2 ou 2' décrite plus haut. Chaque aiguille de la carte à pointes fléchit lors du contact avec une plage correspondante d'un des circuits. Il est donc nécessaire que les aiguilles ne se chevauchent pas dans la réalisation de telles cartes pour éviter de les court-circuiter.

Il est à noter que pour obtenir ce décalage des plages 22, il est également nécessaire, lors de la réalisation des circuits intégrés sur plaquette de silicium, que les masques de chaque étape du procédé de fabrication soient également prévus pour que chaque circuit intégré d'un groupe de quatre circuits intégrés soit tourné de ±90° par rapport à son voisin immédiat Bien entendu, dans une telle réalisation, il est préférable que la forme de chaque circuit soit carrée afin de ne pas perdre de la place sur la plaquette.

Le signal de référence externe 3 sur cette figure 3 représente la tension de référence externe Vréf ext qui est appliquée par les aiguilles 21 sur les plages d'entrée 2. On aurait également pu représenter le signal à fréquence de référence externe appliquée sur une autre plage d'entrée de chaque circuit s'il était nécessaire d'opérer un calibrage du module de tension de référence et du module oscillateur.

Une fois que les quatre circuits intégrés du substrat semi-conducteur ont été testés et calibrés, les aiguilles 20 de la carte à pointes sont soulevées et déplacées dans la direction H pour venir se poser sur quatre autres circuits intégrés à tester et à calibrer. L'emplacement des aiguilles sur les quatre autres circuits est représenté en traits interrompus.

La figure 4, les aiguilles 20 d'une carte à pointes multiples se posent sur les plages 22 de quatre circuits intégrés 1 disposés en ligne. Chaque circuit intégré a toutes les plages d'entrée et de sortie 22 disposées le long de deux bords opposés. Dans cette configuration, la réalisation d'une carte à pointes destinées à connecter au moins quatre circuits intégrés est facilitée. Même si uniquement quatre circuits intégrés sont représentés dans cette figure 4 pour être testés et calibrés en parallèle, il est évident que la conception d'une carte à pointes se posant par exemple sur 8 circuits intégrés disposés en ligne ne poserait pas de réelles difficultés supplémentaires à l'exception éventuellement de l'alignement des aiguilles à poser sur un nombre de plages plus important.

Dans cette figure 4, il n'est représenté que le signal à fréquence de référence externe 13 relié aux aiguilles 21' de la carte à pointes connectant les plages 2', mais comme précédemment un signal de tension de référence externe 3 pourrait également être appliqué sur une autre plage d'entrée de chaque circuit pour le cas où le module oscillateur et le module de tension de référence sont à calibrer.

Une fois l'opération de test et de calibrage terminée pour les quatre circuits intégrés, les aiguilles 20 de la carte à pointes sont soulevées et déplacées dans la direction H pour venir se poser sur quatre autres circuits intégrés à tester et à calibrer, comme expliqué ci-dessus. L'emplacement des aiguilles 20 dans cette autre position est représenté en traits interrompus.

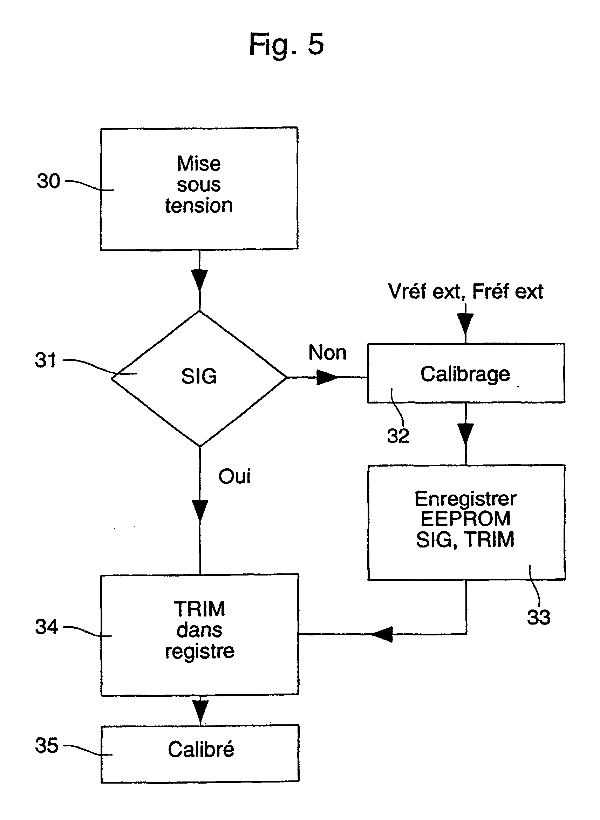

Dès la mise sous tension et l'apport d'un signal de référence externe, le circuit intégré va contrôler s'il doit se calibrer ou si par contre cette opération a été déjà exécutée. La figure 5 illustre la procédure de contrôle et de calibrage de circuits intégrés.

Tout d'abord, le circuit intégré est mis sous tension 30 que ce soit pour un circuit en phase de test d'une plaquette de circuits ou pour un circuit séparé de la plaquette. A cette fin, une source d'alimentation est connectée sur deux plages métalliques du circuit intégré. Dès la mise sous tension, un contrôle est effectué pour savoir si une opération de calibrage des modules de référence a déjà été réalisée précédemment. Une mémoire EEPROM comprend le ou les mots de calibrage enregistrés et une signature associée à chaque mot de calibrage d'un module de référence correspondant.

Au cas où il n'y a pas de signature 31 enregistrée dans ladite mémoire, correspondant aux mots de calibrage, une opération de calibrage 32 peut avoir lieu. Au moins un signal de référence externe, par exemple Vréf ext et/ou Fréf ext, est introduit par une plage métallique d'entrée du circuit pour que le calibrage du ou des modules de référence puisse se faire. Dès que ce calibrage est terminé, les paramètres finals de calibrage, c'est-à-dire le mot de calibrage, sont enregistrés dans la mémoire EEPROM 33 avec la signature associée. Chaque mot de calibrage avec sa signature correspond aux paramètres de calibrage d'un des modules de référence. Finalement, les paramètres finals de calibrage sont placés dans le registre 34 pour que le module de référence soit calibré 35.

Par contre si, après la mise sous tension 30, une signature est déjà enregistrée dans la mémoire EEPROM, cette dernière grâce au microprocesseur va transmettre les paramètres de calibrage (mot de calibrage) au registre 34 du module de référence pour qu'il soit calibré 35.

Normalement, l'enregistrement des paramètres finals de calibrage dans la mémoire pour le module de référence correspondant est permanent, ce qui veut dire que même si on applique un signal de référence autre que celui désiré initialement, il n'y aura plus d'autre opération de calibrage, car le circuit sous tension va retrouver la signature desdits paramètres dans la mémoire EEPROM.

Il est à noter que même si la description précédente a été faite avec un enregistrement permanent des paramètres finals de calibrage avec la signature associée, cela n'exclut pas la possibilité de pouvoir opérer néanmoins un calibrage de circuits sur plaquette ou de circuits déjà isolés après sciage de ladite plaquette. Cette opération ultérieure donne la possibilité de pouvoir pallier certaines dérives de paramètres électriques dues par exemple au vieillissement des circuits ou aux effets de la température. Dans cet ordre d'idée, les circuits subissent donc un recalibrage de leurs modules de référence.

A partir de la description qui vient d'être faite, de multiple variantes de réalisation peuvent être conçues sans sortir du cadre de l'invention à la connaissance de l'homme du métier. Par exemple, au lieu d'utiliser des cartes à pointes pour le test et le calibrage de plusieurs circuits en parallèle, il aurait pu être envisagé de connecter les circuits intégrés de !a plaquette par des pistes métalliques passant par les bandes de sciage qui sont détruites à l'opération de sciage. Deux pistes métalliques amènent la tension d'alimentation de chaque circuit, tandis qu'une ou deux pistes métalliques sont destinées à amener un ou deux signaux de référence pour le calibrage d'un ou deux modules de référence de chaque circuit intégré.

## Revendications

1. Circuit intégré (1) pourvu de moyens de calibrage en phase de test d'au moins un module électronique, lesdits moyens de calibrage étant prévus pour calibrer de manière autonome au moins un module électronique de référence intégré (9, 19) en fonction d'un signal de référence externe (3, 13) introduit dans le circuit par une plage d'entrée (2, 2') du circuit et pour enregistrer des paramètres finals de calibrage **caractérisé en ce que** les paramètres finals de calibrage sont enregistrés avec une signature associée lorsque le signal de sortie du module de référence est égal au signal de référence externe (3, 13), la présence de ladite signature permettant, lors de la mise sous tension du circuit intégré, de transmettre les paramètres de calibrage enregistrés audit module de référence intégré (9,19), une opération de calibrage pouvant par ailleurs avoir lieu en cas d'absence de ladite signature.

2. Circuit intégré selon la revendication 1, **caractérisé en ce que** les moyens de calibrage comprennent des moyens de comparaison (4, 14) destinés à recevoir en entrée le signal de sortie du module de référence (9, 19) et le signal de référence externe (3, 13), et à fournir en sortie un signal de comparaison, un microprocesseur (6) pour gérer le calibrage dudit module de référence (9, 19) en fonction du signal de comparaison reçu, des moyens de comparaison (4, 14), une première mémoire (7) comprenant un algorithme de calcul liée au microprocesseur (6) pour lui permettre de calculer des paramètres de calibrage en fonction du signal de comparaison, et une deuxième mémoire (10) liée au microprocesseur (6) pour enregistrer les paramètres finals (12) de calibrage dudit module ainsi qu'une signature (11) associée auxdits paramètres.

3. Circuit intégré selon la revendication 2, **caractérisé en ce que** le module de référence (9, 19) fournit en sortie une tension de référence (Vréf int), et **en ce que** les moyens de comparaison sont un comparateur (4) dont les deux entrées reçoivent la tension de référence (Vréf int) du module à calibrer et une tension de référence externe (Vréf ext).

4. Circuit intégré selon la revendication 2, **caractérisé en ce que** le module de référence est un oscillateur (19) fournissant en sortie un signal à fréquence de référence (Fréf int), et **en ce que** les moyens de comparaison sont un compteur (14) dont deux entrées reçoivent le signal à fréquence de référence (Fréf int) de l'oscillateur (19) et le signal à fréquence de référence externe (Fréf ext).

5. Circuit intégré selon l'une des revendications précédentes, **caractérisé en ce qu'**il comprend un premier module de référence (9) fournissant en sortie une tension de référence (Vréf int) et un second module de référence (19) fournissant en sortie un signal à fréquence de référence (Fréf int), **en ce que** ledit circuit reçoit sur une première plage d'entrée (2) une tension de référence externe (Vréf ext) pour calibrer le premier module de référence (9) et sur une deuxième plage d'entrée (2') un signal à fréquence de référence externe (Fréf ext) pour calibrer le deuxième module de référence (19).

6. Circuit intégré selon la revendication 1, **caractérisé en ce que** le module de référence fournit en sortie un signal de base de temps qui est comparé dans des moyens de comparaison des moyens de calibrage à un signal de base de temps externe.

7. Circuit intégré selon la revendication 2, **caractérisé en ce que** la première mémoire est une mémoire ROM (7), **en ce que** la deuxième mémoire est une mémoire EEPROM (10), et **en ce qu'**un registre de données (8, 18) est placé en tant qu'interface à l'entrée du module de référence pour recevoir les paramètres de calibrage.

8. Procédé de calibrage en phase de test d'au moins un module électronique intégré de référence (9, 19) d'au moins un circuit intégré (1) selon l'une des revendications précédentes, comprenant les étapes de :
a) alimenter le circuit intégré (1) par une source de tension électrique externe,
b) appliquer sur une des plages d'entrée (2, 2') du circuit intégré un signal de référence externe (3, 13) en liaison avec des moyens de calibrage du circuit intégré (1) pour qu'ils calibrent de manière autonome par itération le module électronique de référence (9, 19) à l'aide de paramètres de calibrage jusqu'à ce que le signal de sortie de référence du module de référence soit égal au signal de référence externe (3, 13), et,
c) enregistrer les paramètres finals (12) de calibrage fournis par les moyens de calibrage, **caractérisé en ce que** les paramètres finals de calibrage sont enregistrés ainsi qu'une signature (11) associée auxdits paramètres dans des moyens de mémorisation (10), la présence de ladite signature permettant, lors de la mise sous tension du circuit intégré, de transmettre les paramètres de calibrage enregistrés audit module de référence intégré (9,19), une opération de calibrage pouvant par ailleurs avoir lieu en cas d'absence de ladite signature.

9. Procédé selon la revendication 8, **caractérisé en ce que**, à l'étape b) dans les moyens de calibrage, le signal de référence externe (3, 13) est comparé avec le signal de sortie du module de référence (9, 19) dans des moyens de comparaison (4, 14), **en ce que** les paramètres de calibrage sont calculés dans un microprocesseur (6) en fonction du signal de sortie des moyens de comparaison (4, 14) et sur la base d'un algorithme de calcul d'une première mémoire (7) liée au microprocesseur (6), **en ce que** les paramètres de calibrage sont appliqués au module de référence (9, 19) pour modifier son signal de sortie de référence, **en ce qu'**on répète les opérations précédentes jusqu'à ce que le signal de référence du module soit égal au signal de référence externe (3, 13), et **en ce que** les paramètres finals (12) de calibrage sont enregistrés de manière permanente depuis le microprocesseur (6) dans une deuxième mémoire (10) correspondant aux moyens de mémorisation avec une signature (11) associée aux paramètres finals pour qu'à chaque fois que ledit circuit est mis sous tension la deuxième mémoire (10) fournisse automatiquement au microprocesseur (6) les paramètres finals de calibrage à appliquer au module de référence (9, 19) pour qu'il fournisse un signal de référence interne calibré.

10. Procédé de calibrage selon l'une des revendications 8 et 9, **caractérisé en ce que** plusieurs circuits intégrés (1) d'un même substrat semi-conducteur sont alimentés en tension et se calibrent de manière autonome en même temps à l'aide d'un même signal de référence externe appliqué sur la plage d'entrée (2, 2') correspondante de chaque circuit en phase de test.

11. Procédé de calibrage selon la revendication 10, **caractérisé en ce que** les aiguilles d'une carte à pointes multiple (20) d'une machine de test viennent se poser sur les plages d'entrée et de sortie de signaux d'au moins deux circuits intégrés voisins, de préférence quatre circuits intégrés voisins, pour qu'ils se calibrent de manière autonome en même temps.

12. Procédé de calibrage selon la revendication 8, **caractérisé en ce que** chaque circuit intégré comprend un premier module de référence (9) fournissant en sortie une tension de référence (Vréf int) et un second module de référence (19) fournissant en sortie un signal à fréquence de référence (Fréf int), **en ce que** ledit circuit reçoit sur une première plage d'entrée (2) une tension de référence externe (Vréf ext) pour calibrer le premier module de référence (9) et sur une deuxième plage d'entrée (2') un signal à fréquence de référence externe (Fréf ext) pour calibrer le deuxième module de référence (19).

13. Plaquette de circuits intégrés selon l'une des revendications 1 à 7, **caractérisée en ce que** lesdits circuits intégrés (1) sont disposés sur la plaquette en groupes de circuits voisins et semblables qui ont des orientations différentes de manière que l'emplacement de leurs plages (22) d'entrée et de sortie de signaux permettent aux aiguilles (21) d'une carte à pointes d'une machine de test de pouvoir se poser sur les plages (22) d'un des groupes de circuits intégrés (1) pour pouvoir tester et calibrer tous les circuits du groupe en même temps.

14. Plaquette selon la revendication 13, **caractérisée en ce que** le groupe de circuits intégrés (1) comprend quatre circuits intégrés voisins, dont les circuits sont disposés sur deux lignes parallèles de manière à former un groupe sensiblement carré, chaque circuit étant tourné par rapport à son voisin immédiat de ±90° de manière que toutes les plages (22) se trouvent en périphérie du groupe.

## Patentansprüche

1. Integrierte Schaltung (1), die mit Mitteln zum Kalibrieren wenigstens eines elektronischen Moduls während einer Testphase versehen ist, wobei die Kalibrierungsmittel dazu vorgesehen sind, in selbständiger Weise wenigstens ein integriertes elektronisches Referenzmodul (9, 19) in Abhängigkeit von einem externen Referenzsignal (3, 13), das in die Schaltung über eine Eingangsanschlußfläche (2, 2') der Schaltung eingegeben wird, zu kalibrieren und Endparameter der Kalibrierung aufzuzeichnen, **dadurch gekennzeichnet, daß** die Endparameter der Kalibrierung mit einer zugeordneten Signatur aufgezeichnet werden, wenn das Ausgangssignal des Referenzmoduls gleich dem externen Referenzsignal (3, 13) ist, wobei das Vorhandensein der Signatur ermöglicht, beim Anlegen der Spannung an die integrierte Schaltung die aufgezeichneten Kalibrierungsparameter an das integrierte Referenzmodul (9, 19) zu übertragen, wobei eine Kalibrierungsoperation auch bei Abwesenheit der Signatur stattfinden kann.

2. Integrierte Schaltung nach Anspruch 1, **dadurch gekennzeichnet, daß** die Kalibrierungsmittel Vergleichsmittel (4, 14), die dazu vorgesehen sind, am Eingang das Ausgangssignal des Referenzmoduls (9, 19) und das externe Referenzsignal (3, 13) zu empfangen und am Ausgang ein Vergleichssignal zu liefern, einen Mikroprozessor (6), der die Kalibrierung des Referenzmoduls (9, 19) in Abhängigkeit von dem empfangenen Vergleichssignal der Vergleichsmittel (4, 14) steuert, einen ersten Speicher (7), der einen Rechenalgorithmus enthält und mit dem Mikroprozessor (6) verbunden ist, um diesem zu ermöglichen, Kalibrierungsparameter in Abhängigkeit von dem Vergleichssignal zu berechnen, und einen zweiten Speicher (10), der mit dem Mikroprozessor (6) verbunden ist, um die Endparameter (12) der Kalibrierung des Moduls sowie eine den Parametern zugeordnete Signatur (11) aufzuzeichnen, umfassen.

3. Integrierte Schaltung nach Anspruch 2, **dadurch gekennzeichnet, daß** das Referenzmodul (9, 19) am Ausgang eine Referenzspannung (Vref int) liefert und daß die Vergleichsmittel ein Komparator (4) sind, dessen zwei Eingänge die Referenzspannung (Vref int) des zu kalibrierenden Moduls und eine externe Referenzspannung (Vref ext) empfangen.

4. Integrierte Schaltung nach Anspruch 2, **dadurch gekennzeichnet, daß** das Referenzmodul ein Oszillator (19) ist, der am Ausgang ein Signal mit Referenzfrequenz (Fref int) liefert, und daß die Vergleichsmittel ein Zähler (14) sind, dessen zwei Eingänge das Signal mit Referenzfrequenz (Fref int) des Oszillators (19) und das Signal mit externer Referenzfrequenz (Fref ext) empfangen.

5. Integrierte Schaltung nach einem der vorhergehenden Ansprüche, **dadurch gekennzeichnet, daß** sie ein erstes Referenzmodul (9), das am Ausgang eine Referenzspannung (Vref int) liefert, und ein zweites Referenzmodul (19), das am Ausgang ein Signal mit Referenzfrequenz (Fref int) liefert, umfaßt, daß die Schaltung an einer ersten Eingangsanschlußfläche (2) eine externe Referenzspannung (Vref ext) empfängt, um das erste Referenzmodul (9) zu kalibrieren, und an einer zweiten Eingangsanschlußfläche (2) ein Signal mit externer Referenzfrequenz (Fref ext) empfängt, um das zweite Referenzmodul (19) zu kalibrieren.

6. Integrierte Schaltung nach Anspruch 1, **dadurch gekennzeichnet, daß** das Referenzmodul am Ausgang ein Taktsignal liefert, das in den Vergleichsmitteln der Kalibrierungsmittel mit einem externen Taktsignal verglichen wird.

7. Integrierte Schaltung nach Anspruch 2, **dadurch gekennzeichnet, daß** der erste Speicher ein ROM-Speicher (7) ist, daß der zweite Speicher ein EEPROM-Speicher (10) ist und daß ein Datenregister (8, 18) als Schnittstelle am Eingang des Referenzmoduls angeordnet ist, um die Kalibrierungsparameter zu empfangen.

8. Verfahren zum Kalibrieren wenigstens eines integrierten elektronischen Referenzmoduls (9, 19) wenigstens einer integrierten Schaltung (1) nach einem der vorhergehenden Ansprüche während einer Testphase, das die folgenden Schritte umfaßt:
a) Versorgen der integrierten Schaltung (1) mit einer externen Quelle für elektrische Spannung,
b) Eingeben eines externen Referenzsignals (3, 13) in eine der Eingangsanschlußflächen (2, 2') der integrierten Schaltung in Verbindung mit den Kalibrierungsmitteln der integrierten Schaltung (1), damit sie in selbständiger Weise durch Iteration das elektronische Referenzmodul (9, 19) mit Hilfe von Kalibrierungsparametern kalibrieren, bis das Referenzausgangssignal des Referenzmoduls gleich dem externen Referenzsignal (3, 13) ist, und
c) Aufzeichnen der Endparameter (12) der Kalibrierung, die von den Kalibrierungsmitteln geliefert werden, **dadurch gekennzeichnet, daß** die Endparameter der Kalibrierung sowie eine den Parametern zugeordnete Signatur (11) in Speichermitteln (10) aufgezeichnet werden, wobei das Vorhandensein der Signatur ermöglicht, beim Anlegen der Spannung an die integrierte Schaltung die aufgezeichneten Kalibrierungsparameter an das integrierte Referenzmodul (9, 19) zu übertragen, wobei eine Kalibrierungsoperation auch bei Abwesenheit der Signatur stattfinden kann.

9. Verfahren nach Anspruch 8, **dadurch gekennzeichnet, daß** im Schritt b) in den Kalibrierungsmitteln das externe Referenzsignal (3, 13) mit dem Ausgangssignal des Referenzmoduls (9, 19) in den Vergleichsmitteln (4, 14) verglichen wird, daß die Kalibrierungsparameter in einem Mikroprozessor (6) in Abhängigkeit vom Ausgangssignal der Vergleichsmittel (4, 14) und auf der Grundlage eines Rechenalgorithmus eines mit dem Mikroprozessor (6) verbundenen ersten Speichers (7) berechnet werden, daß die Kalibrierungsparameter in das Referenzmodul (9, 19) eingegeben werden, um dessen Referenzausgangssignal zu modifizieren, daß die vorhergehenden Operationen wiederholt werden, bis das Referenzsignal des Moduls gleich dem externen Referenzsignal (3, 13) ist, und daß die Endparameter (12) der Kalibrierung in dauerhafter Weise vom Mikroprozessor (6) in einem zweiten Speicher (10), der den Speichermitteln entspricht, zusammen mit einer den Endparametern zugeordneten Signatur (11) aufgezeichnet werden, damit der zweite Speicher (10) jedesmal, wenn an die Schaltung eine Spannung angelegt wird, automatisch an den Mikroprozessor (6) die Endparameter der Kalibrierung liefert, um sie in das Referenzmodul (9, 19) einzugeben, damit es ein kalibriertes internes Referenzsignal liefert.

10. Kalibrierungsverfahren nach einem der Ansprüche 8 und 9, **dadurch gekennzeichnet, daß** mehrere integrierte Schaltungen (1) auf demselben Halbleitersubstrat mit einer Spannung versorgt werden und sich in selbständiger Weise gleichzeitig mit Hilfe desselben externen Referenzsignals, das während der Testphase an die entsprechende Eingangsanschlußfläche (2, 2') jeder Schaltung angelegt wird, kalibrieren.

11. Kalibrierungsverfahren nach Anspruch 10, **dadurch gekennzeichnet, daß** die Stifte einer Mehrfachspitzen-Karte (20) einer Testmaschine auf den Signaleingangs- und Signalausgangs-Anschlußflächen wenigstens zweier benachbarter integrierter Schaltungen, vorzugsweise auf vier benachbarten integrierten Schaltungen, zu liegen kommen, damit diese sich in selbständiger Weise gleichzeitig kalibrieren.

12. Kalibrierungsverfahren nach Anspruch 8, **dadurch gekennzeichnet, daß** jede integrierte Schaitung ein erstes Referenzmodul (9), das am Ausgang eine Referenzspannung (Vref int) liefert, und ein zweites Referenzmodul (19), das am Ausgang ein Signal mit Referenzfrequenz (Fref int) liefert, umfaßt, daß die Schaltung an einer ersten Eingangsanschlußfläche (2) eine externe Referenzspannung (Vref ext) empfängt, um das erste Referenzmodul (9) zu kalibrieren, und an einer zweiten Eingangsanschlußfläche (2') ein Signal mit externer Referenzfrequenz (Fref ext) empfängt, um das zweite Referenzmodul (19) zu kalibrieren.

13. Chip für integrierte Schaltungen nach einem der Ansprüche 1 bis 7, **dadurch gekennzeichnet, daß** die integrierten Schaltungen (1) auf dem Chip in Gruppen benachbarter und ähnlicher Schaltungen angeordnet sind, die unterschiedliche Orientierungen besitzen, derart, daß der Ort ihrer Signaleingangs- und Signalausgangs-Anschlußflächen (22) den Stiften (21) einer Karte mit Spitzen einer Testmaschine ermöglicht, auf den Anschlußflächen (22) einer der Gruppen aus integrierten Schaltungen (1) zu liegen zu kommen, um sämtliche Schaltungen der Gruppe gleichzeitig testen und kalibrieren zu können.

14. Chip nach Anspruch 13, **dadurch gekennzeichnet, daß** die Gruppe (1) aus integrierten Schaltungen vier benachbarte integrierte Schaltungen umfaßt, deren Schaltungen auf zwei parallelen Linien in der Weise angeordnet sind, daß eine im wesentliche quadratische Gruppe gebildet wird, wobei jede Schaltung in bezug auf ihren direkten Nachbarn um ±90° gedreht ist, so daß sich sämtliche Anschlußflächen (22) am Umfang der Gruppe befinden.

## Claims

1. Integrated circuit (1) provided with means for calibrating in test phase at least one electronic module, said calibrating means being provided to calibrate in an autonomous manner at least one integrated reference electronic module (9, 19) as a function of an external reference signal (3, 13) introduced into the circuit by an input pad (2, 2') of the circuit and to store the final calibrating parameters, **characterised in that** the final calibrating parameters are stored with an associated signature when the output signal of the reference module is equal to the external reference signal (3, 13), the presence of said signature allowing, during the power-on of the integrated circuit, to transmit the stored calibrating parameters to said integrated reference module (9, 19), a calibrating operation further being able to occur in case of absence of said signature.

2. Integrated circuit according to claim 1, **characterised in that** the calibrating means include comparing means (4, 14) intended to receive at its input the output signal of the reference module (9, 19) and the external reference signal (3, 13), and to provide at its output a comparison signal, a microprocessor (6) for controlling the calibration of said reference module (9, 19) as a function of the comparison signal received from the comparing means (4, 14), a first memory (7) including a calculating algorithm connected to the microprocessor (6) to allow it to calculate calibrating parameters as a function of the comparison signal, and a second memory (10) connected to the microprocessor (6) to store the final calibrating parameters (12) of said module as well as a signature (11) associated with said parameters.

3. Integrated circuit according to claim 2, **characterised in that** the reference module (9, 19) supplies at its output a reference voltage (Vref int), and **in that** the comparing means are a comparator (4) whose two inputs receive the reference voltage (Vref int) from the module to be calibrated and an external reference voltage (Vref ext).

4. Integrated circuit according to claim 2, **characterised in that** the reference module is an oscillator (19) supplying at its output a reference frequency signal (Fref int), and **in that** the comparing means are a counter (14) two inputs of which receive the reference frequency signal (Fref int) from the oscillator (19) and the external reference frequency (Fref ext).

5. Integrated circuit according to any of the preceding claims, **characterised in that** it includes a first reference module (9) supplying at its output a reference voltage (Vref int) and a second reference module (19) supplying at its output a reference frequency signal (Fref int), **in that** said circuit receives at a first input pad (2) an external reference voltage (Vref ext) for calibrating the first reference module (9), and at a second input pad (2') an external reference frequency signal (Fref ext) for calibrating the second reference module (19).

6. Integrated circuit according to claim 1, **characterised in that** the reference module supplies at its output a time base signal which is compared in the comparing means of the calibrating means to an external time base signal.

7. Integrated circuit according to claim 2, **characterised in that** the first memory is a ROM memory (7), **in that** the second memory is an EEPROM memory (10), and **in that** a data register (8, 18) is placed as an interface at the input of the reference module to receive the calibrating parameters.

8. Method for calibrating in test phase at least one integrated reference electronic module (9, 19) of at least one integrated circuit (1) according to any of the preceding claims including the steps of:
a) powering the integrated circuit (1) via an external electric power source;
b) applying on one of the input pads (2, 2') of the integrated circuit an external reference signal (3, 13) in conjunction with calibrating means of the integrated circuit (1) so that they calibrate autonomously by iterating the reference electronic module (9, 19) using calibrating parameters until the reference output signal of the reference module is equal to the external reference signal (3, 13); and
c) storing the final calibrating parameters (12) provided by the calibrating means, **characterised in that** the final calibrating parameters are stored with a signature (11) associated with said parameters in memory means (10), the presence of said signature allowing, during the power-on of the integrated circuit, to transmit the stored calibrating parameters to said integrated reference module (9, 19), a calibrating operation further being able to occur in case of absence of said signature.

9. Method according to claim 8, **characterised in that**, at step b) in the calibrating means, the external reference signal (3, 13) is compared with the output signal of the reference module (9, 19) in comparing means (4, 14), **in that** the calibrating parameters are calculated in a microprocessor (6) as a function of the output signal of the comparing means (4, 14) and on the basis of a calculating algorithm of a first memory (7) connected to the microprocessor (6), **in that** the calibrating parameters are applied to the reference module (9, 19) to modify its reference output signal, **in that** the preceding operations are repeated until the reference signal of the module is equal to the external reference signal (3, 13), and **in that** the final calibrating parameters (12) are permanently stored from the microprocessor (6) in a second memory (10) corresponding to the memory means with a signature (11) associated with the final parameters so that each time that voltage is applied to said circuit, the second memory (10) automatically provides the microprocessor (6) with the final calibrating parameters to be applied to the reference module (9, 19) so that it provides a calibrated internal reference signal.

10. Calibrating method according to any of claims 8 and 9, **characterised in that** several integrated circuits (1) of a same semiconductor substrate are supplied with voltage and are calibrated autonomously at the same time using a same external reference signal applied to the corresponding input pad (2, 2') of each circuit in test phase.

11. Calibrating method according to claim 10, **characterised in that** the probes of a multiple probe card (20) of a test machine are placed on the signal input and output pads of at least two neighbouring circuits, preferably four neighbouring integrated circuits, so that they are calibrated autonomously at the same time.

12. Calibration method according to claim 8, **characterised in that** each integrated circuit includes a first reference module (9) supplying at its output a reference voltage (Vref int) and a second reference module (19) supplying at its output a reference frequency signal (Fref int), **in that** said circuit receives at a first input pad (2) an external reference voltage (Vref ext) for calibrating the first reference module (9) and at a second input pad (2') an external reference frequency signal (Fref ext) for calibrating the second reference module (19).

13. Wafer of integrated circuits according to any of claims 1 to 7, **characterised in that** said integrated circuits (1) are disposed on the wafer in groups of neighbouring and similar circuits which are oriented differently so that the location of their signal input and output pads (22) allow the probes (21) of a probe card of a test machine to be placed on the pads (22) of a group of integrated circuits (1) to be able to test and calibrate all the circuits of the group at the same time.

14. Wafer according to claim 13, **characterised in that** the group of integrated circuits (1) includes four neighbouring integrated circuits, wherein the circuits are disposed on two parallel lines so as to form a substantially square group, each circuit being rotated with respect to its immediate neighbour by ± 90° so that all the pads (22) are located at the periphery of the group.
